# EUROPÄISCHE PATENTSCHRIFT

(11) **EP 1 720 169 B1**
(45) Veröffentlichungstag und Bekanntmachung des Hinweises auf die Patenterteilung: **16.11.2011**
(21) Anmeldenummer: 06008992.7
(22) Anmeldetag: 29.04.2006
(51) Int. Cl.: G11C 16/10

(54) **Nichtflüchtige Speichereinrichtung mit einer Programmier- und Löschkontrolle**
Non-volatile storage device comprising programming and erasing control
Mémoire non volatile pourvue d'un contrôle de programmation et de suppression

(30) Priorität: 04.05.2005 DE 102005020808
(43) Veröffentlichungstag der Anmeldung: 08.11.2006
(73) Patentinhaber: Micronas GmbH, 79108 Freiburg (DE)
(72) Erfinder: Ullrich, Manfred, 79211 Denzlingen (DE); Bayer, Martin, 79279 Vörstetten (DE); Fink, Hans-Jörg, 79108 Freiburg (DE); Bidenbach, Reiner, 79279 Vörstetten (DE); Rubehn, Thilo, 79194 Gundelfingen (DE)
(74) Vertreter: Koch Müller Patentanwaltsgesellschaft mbH

(56) Entgegenhaltungen:
- US-A- 5 621 687
- US-B1- 6 822 909

## Beschreibung

Bei nichtflüchtigen Speichereinrichtungen ergibt sich oft die Schwierigkeit, dass nicht erkennbar ist, ob die nichtflüchtigen Speicherzellen ihre gespeicherten Werte über die vorgesehene Lebensdauer behalten. Dies kann mit einer Schädigung der Speichereinrichtung zusammenhängen, die zwar aktuell noch keinen Totalausfall bewirkt, aber höchstwahrscheinlich einen vorzeitigen Speicherverlust zur Folge hat.

Aufgabe der Erfindung ist es, für eine nichtflüchtige Speichereinrichtung ein Verfahren mit zugehöriger Schaltung anzugeben, das möglichst im normalen Betrieb ein Erkennen der geschädigten Speichereinrichtungen erlaubt, um entsprechende Schutzvorkehrungen zu treffen.

Die Erfindung geht von der Erkenntnis aus, dass sich eine beginnende oder bereits vorhandene Schädigung von nichtflüchtigen Speichereinrichtungen anfangs meist darin zeigt, dass unter ungünstigen äußeren Bedingungen die übliche Programmierung oder Löschung nicht mehr erfolgreich ist. Dieses Verhalten wird zur Prüfung der Zuverlässigkeit der Speichereinrichtung benutzt, indem die Speichereinrichtung mit einer oder mehreren zusätzlichen Kontrollzellen ausgestattet wird, die zwar gleichartig zu den normalen Speicherzellen sind und zeitgleich mit diesen programmiert oder gelöscht werden, aber unter definiert ungünstigeren Bedingungen. Wird nach der erfolgten ungünstigeren Programmierung oder Löschung bei einer dieser Kontrollzellen festgestellt, dass die erwartete Programmierung oder Löschung nicht eingetreten ist, dann ist das ein erster Hinweis darauf, dass die Speichereinrichtung geschädigt sein kann. In der Regel wird dann der Speichervorgang wiederholt, um eventuell zufällig vorhandene externe Störung auszuschließen. Tritt die Fehlermeldung dann nochmals auf, kann man ziemlich sicher sein, dass eine Schädigung der Speichereinrichtung vorliegt. Da die Prüfung in bestimmten Intervallen oder bei jedem Speichervorgang erfolgt, können entsprechende Sicherungsmaßnahmen durch den in der Regel stets angeschlossenen Prozessor automatisch ausgelöst werden.

Damit die ungünstigeren Bedingungen für die Programmierung oder Löschung definiert und reproduzierbar sind, werden entweder die Kontrollzellen ungünstiger ausgelegt oder man gibt als ungünstigere Bedingung mindestens einen der Programmier- oder Löschparameter definiert ungünstiger vor als bei den eigentlichen Speicherzellen. Folgende Parameter sind dabei denkbar: die Zeit in der die Programmier- oder Löschspannung anliegt, ihre Höhe, die Spannungshöhe der zu speichernden logischen "0" oder "1", die resultierende Differenzspannung, die über der schwebenden Steuerelektrode (=floating-gate) der Speicherzelle liegt oder die Ladungsmenge und damit Spannungshöhe in der Speicherzelle, die bei dem Programmier- oder Löschvorgang umgeladen werden muss.

Damit der Kontrollvorgang in den normalen Programmier- und Löschvorgang integriert wird und nicht als separater Vorgang abläuft, sind mindestens zwei Kontrollzellen erforderlich. In der einen Kontrollzelle erfolgt der aktuelle Speichervorgang unter ungünstigen Bedingungen und in der anderen Kontrollzelle findet eine Vorbereitung auf den nächsten Speichervorgang statt. Zur Ansteuerung der beiden Kontrollzellen ist daher ein mindestens zwei Stellen umfassendes Datenwort erforderlich. Ein bevorzugtes Ausführungsbeispiel, das noch genauer beschrieben wird, verwendet drei Kontrollzellen und eine zusätzliche Speicherzelle und benötigt daher ein Datenwort mit vier Stellen. Durch die Verwendung von drei Kontrollzellen in Verbindung mit einer separaten Speicherzelle, aus der die letzte Speicheroperation hervorgeht, lassen sich eindeutige vierstellige Zustände definieren, die erkennen lassen, ob der aktuell durchgeführte Speichervorgang erfolgreich war oder nicht. Die Auswertung erfolgt mittels einer logischen Auswerteeinrichtung, die je nach dem Ergebnis eine positive oder negative Bestätigungsinformation erzeugt. Besonders geeignet für die Generierung der Datenworte ist eine logische Einrichtung, die aus dem an den Ausgängen der Kontrollzellen abgegriffenen Datenwort, das einen bestimmten Zustand entspricht, ein neues Datenwort bildet, das als neues Testwort den Eingängen der Kontrollzellen zugeführt wird. Im angelsächsischen Sprachgebrauch werden derartige logische Zuordnungseinrichtungen als "state machine" bezeichnet.

Besonders aussagekräftig wird die Überwachung der Speichereigenschaften, wenn für die Auswertung nicht nur der aktuell durchgeführte Speichervorgang ausgewertet wird, sondern auch noch der vorausgehende alternative Speichervorgang zur Verfügung steht. Bei drei Kontrollzellen ist dies bereits möglich. Eine erste Kontrollzelle dient der Prüfung des aktuellen Speichervorganges, eine zweite Zelle zeigt das Ergebnis des vorausgehenden alternativen Speichervorganges an und eine dritte Zelle kann für den nächsten Test mit dem dafür geeigneten Speicherinhalt vorbereitet werden.

Die Auswertung, ob die Programmierung oder Löschung erfolgreich war, stellt eine Auswerteeinrichtung aus der Spannungshöhe des Inhalts mindestens einer Kontrollzelle fest, wobei entweder die tatsächliche Spannungshöhe ausgewertet wird oder die Auswertung über einen Vergleich mit einem oder mehreren Schwellwerten erfolgt. Besonders vorteilhaft ist es, wenn in letzterem Fall genau der oder die Schwellwerte verwendet werden, die bei den eigentlichen Speicherzellen den Inhalt als eine logische "0" oder "1" entscheiden. Einmal sind damit die Entscheidungskriterien bei den normalen Speicherzellen und Kontrollzellen weitgehend identisch und zum anderen werden sofort logische Verknüpfungen mit dem Ergebnis aus den Kontrollzellen ermöglicht.

Die Ansprüche 1 und 16 definieren die Erfindung.

Die Erfindung und vorteilhafte Weiterbildungen werden nun anhand der Figuren der Zeichnung näher erläutert:
Fig. 1 zeigt schematisch als Blockschaltbild eine Speichereinrichtung nach der Erfindung,
Fig. 2 zeigt als Beispiel ein vorteilhaftes Ablaufdiagramm mit drei Kontrollzellen und
Fig. 3 zeigt eine Wahrheitstabelle zur Auswertung bei drei Kontrollzellen.

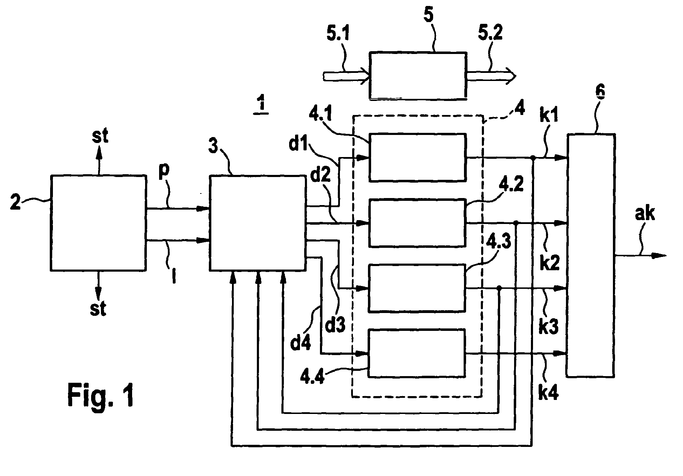

In Fig. 1 sind im wesentlichen nur diejenigen Funktionsbausteine einer nichtflüchtigen Speichereinrichtung 1 dargestellt, die für die Erfindung erforderlich sind. Die eigentlichen Speicherzellen befinden sich in einem Speicherbereich 5, der mit den zugehörigen Busverbindungen 5.1 und 5.2 lediglich angedeutet ist. Die bekannten Funktionseinheiten einer nichtflüchtigen Speichereinrichtung 1 wie Daten- und Signalleitungen, Takteinrichtungen, Einrichtungen für die Daten- und Adressenverwaltung, Spannungsversorgungseinrichtungen usw. werden der besseren Übersicht wegen weggelassen oder sind Teile der dargestellten Funktionseinheiten. So erzeugt eine Steuereinrichtung 2 die erforderlichen Steuersignale st für die gesamte nichtflüchtige Speichereinrichtung 1. Diese enthält entsprechend der Erfindung eine Datenquelle 3 zur Bildung der Eingangdaten für die mindestens eine Kontrollzelle in einem Kontrollbereich 4. Im bevorzugten Ausführungsbeispiel von Fig. 1 besteht der Kontrollbereich 4 aus drei separat von der Datenquelle 3 mit den Eingangsdaten d1, d2, d3 ansteuerbaren Kontrollzellen 4.1, 4.2 und 4.3, die möglichst gleichartig zu den eigentlichen Speicherzellen im Speicherbereich 5 sein sollen. Der Kontrollbereich 4 enthält auch noch eine Aktionszelle 4.4, die von der Datenquelle 3 mit dem Eingangsdatenwert d4 angesteuert wird und in der festgehalten wird, ob der aktuelle Speichervorgang eine Programmierung oder Löschung ist. Das reine Lesen von gespeicherten Daten aus dem normalen Speicherbereich 5 ist zwar auch ein Speichervorgang, für die Kontrollfunktion spielt er jedoch keine Rolle und wird daher im Kontrollbereich 4 auch nicht registriert. Jede Zelle 4.1 bis 4.4 im Kontrollbereich 4 speichert jeweils nur einen logischen Zustand, nämlich eine logische "0" oder eine logische "1". Da die Bildung der Ausgangsdaten d1, d2, d3 und d4 der Datenquelle 3 selbstverständlich davon abhängig ist, ob es sich um den Test einer Programmierung oder Löschung handelt, wird der Datenquelle von der Steuereinrichtung 2 ein entsprechendes Programmier- oder Löschsignal p bzw. 1 zugeführt. Die Steuerung der eigentlichen Programmierung oder Löschung der Speicherzellen im Speicherbereich 5 und im Kontrollbereich 4 erfolgt durch die Steuereinrichtung 2 über übliche Steuersignale st, die zur Vereinfachung in Fig. 1 lediglich angedeutet sind.

Das Auslesen der Speicherzellen 4.1 bis 4.4 im Kontrollbereich 4 erfolgt durch eine Auswerteeinrichtung 6, welche die vier Ausgangsdaten k1 bis k4 der drei Kontrollzellen 4.1 bis 4.3 und der einen Aktionszelle 4.4 parallel oder seriell abfrägt. Aus den ausgelesenen Daten bildet die Auswerteeinrichtung 6 eine Bestätigungs- oder Störungsinformation, die als Ausgangssignal ak zur weiteren Verarbeitung abgegeben wird. Welche Folgen eine Störinformation durch das Ausgangssignal ak dann auslöst, ist nicht mehr Gegenstand der Erfindung. Im einfachsten Fall wird lediglich der Ausfall der Speichereinrichtung signalisiert und gegebenenfalls die Programmierung oder Löschung nochmals durchgeführt. Eine andere Möglichkeit ist, dass das angeschlossene System in einen Neutralzustand ohne die Benutzung der nichtflüchtigen Speichereinrichtung übergeht. Bei mehreren nichtflüchtigen Speichereinrichtungen kann die defekte Einrichtung abgeschaltet und dafür eine andere vorhandene als Ersatz verwendet werden.

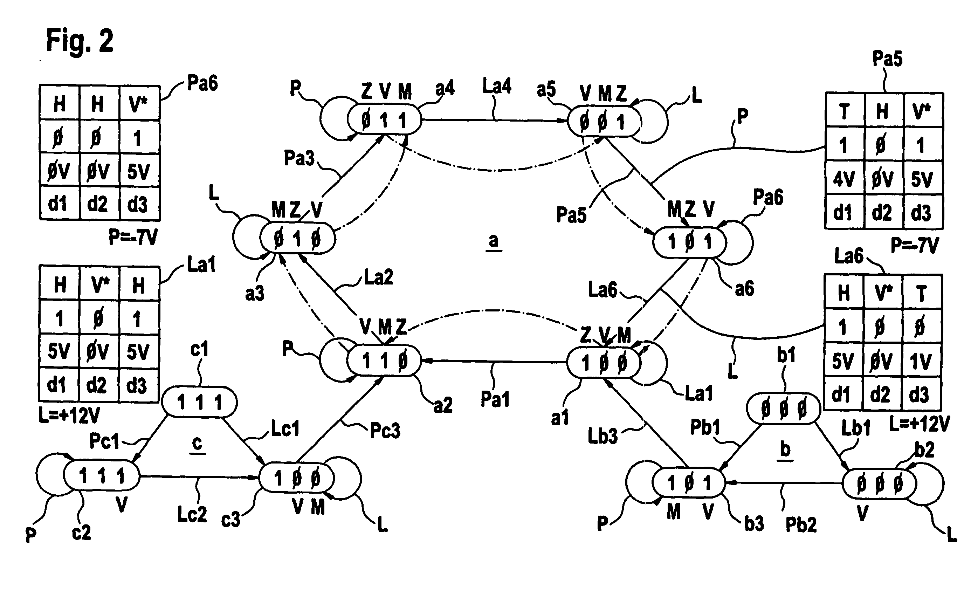

Für das dargestellte Ausführungsbeispiel der Erfindung sind die Rückführungen der Ausgangsdaten k1 bis k4 der vier Ausgängen des Kontrollbereichs 4 zu entsprechenden Eingängen der Datenquelle 3 wichtig. Mit diesen Rückführungen erzeugt die Datenquelle 3 eine logische Zustandfolge, die entsprechend dem jeweiligen Ausgangszustand, der durch die Ausgangsdaten k1 bis k4 des Kontrollbereichs 4 bestimmt ist, die neuen Eingangsdaten d1 bis d4 definiert. In Fig. 2 ist eine derartige Folge als Ablaufdiagramm ausführlich dargestellt. Im angelsächsischen Sprachgebrauch wird diese logische Einrichtung zur Bildung einer definierten Ablauffolge wie bereits erwähnt als "state machine" bezeichnet. Die Zuordnung der einzelnen Folgezustände ist dabei eindeutig, so dass aus einer Abweichung sofort eine Fehlfunktion innerhalb der Schleife feststellbar ist. In der Auswerteeinrichtung 6 muss daher lediglich die Zwangsfolge der durch die Ein- und Ausgangsdaten d1 bis d4 bzw. k1 bi k4 beschriebenen Zustandsfolgen als Tabelle festgehalten sein, gegen die dann die real eingehenden neuen Ausgangsdaten k1 bis k4 verglichen werden. Eine andere Möglichkeit ist die direkte Adressierung einer Tabelle, wenn die Datenausgänge der Datenquelle 3 auch der Auswerteeinrichtung 6 zugeführt sind.

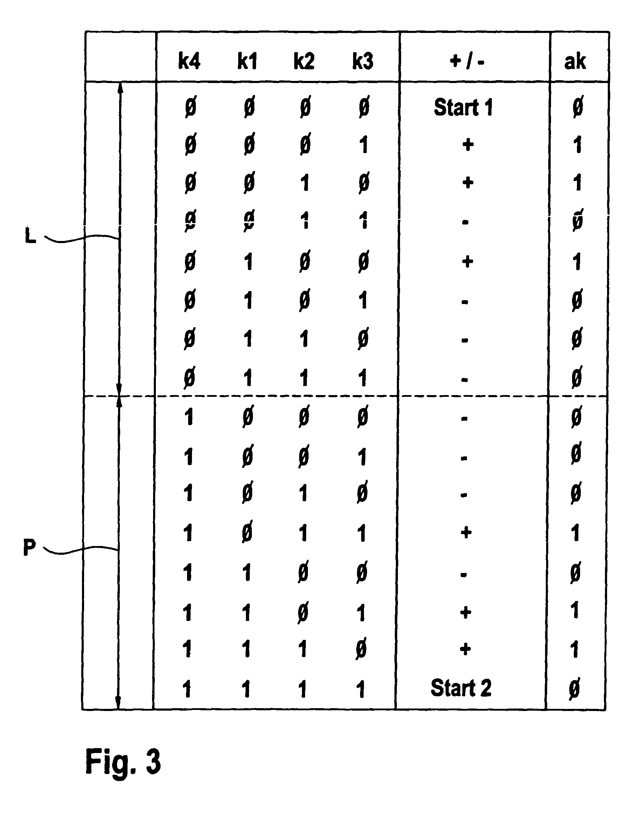

Wenn die Programmierung und die Löschung alternierend aufeinander folgen, ist in jedem Schritt eine Kontrolle möglich und die Zahl der erforderlichen Kontrollzellen wird minimal. Wenn diese alternierende Betriebsweise nicht sicher eingehalten wird, muss entweder die Zahl der Kontrollzellen erhöht werden oder eine Messung ist nur bei einem Wechsel des Speichervorganges möglich. Mit den drei Kontrollzellen 4.1 bis 4.3 und der Aktionszelle 4.4 in dem Ausführungsbeispiel von Fig. 1 wird die Auswertung besonders einfach, denn dann lässt sich der Kontrollvorgang bei einem alternierenden Speicherbetrieb so steuern, dass allein aus dem Ausgangsdatenwort k1 bis k4 des Kontrollbereichs 4 erkennbar ist, ob ein erfolgreicher Speichervorgang vorliegt oder nicht, vergleiche hierzu das Ablaufdiagramm von Fig. 2 und die zugehörige Wahrheitstabelle in Fig. 3.

Fig. 2 zeigt ein vorteilhaftes Ablaufdiagramm unter Verwendung von drei Kontrollzellen 4.1, 4.2 , 4.3 entsprechend dem Ausführungsbeispiel von Fig. 1. Das Diagramm gliedert sich in drei Bereiche, nämlich eine Hauptschleife a und eine erste und zweite Startschleife b bzw. c. In den Eckpunkten der drei Schleifen sind in abgerundeten Feldern von links nach rechts gehend die jeweiligen drei Ausgangszustände k1, k2 und k3 der zugehörigen Kontrollzellen 4.1, 4.2 und 4.3 als logische "0" oder logische "1" dargestellt. Die aufeinanderfolgenden Zustände sind im Diagramm durchnummeriert, wobei die Bezeichnung der jeweiligen Schleife vorausgeht. Die Ablauffolge setzt voraus, dass Programmieren und Löschen alternierend aufeinander folgen. Die Hauptschleife a weist sechs unterschiedliche Zuständen a1 bis a6 auf bis sich die Schleife beim Zustand a1 wieder schließt.

Neben der Hauptschleife a gibt es die erste Startschleife b, die von einem ersten Startwert b1 ausgehend entweder über einen Löschvorgang Lb1 den Zustand b2 oder über einen Programmiervorgang Pb 1 den Zustand b3 erreicht. Der Zustand b3 ist auch über den Zustand b2 erreichbar, wenn dem Zustand b2 ein Programmiervorgang Pb2 folgt. Vom Zustand b3 führt schließlich ein Löschvorgang Lb3 zum Zustand a1 in der Hauptschleife a. Weitere Programmier- oder Löschvorgänge führen nicht mehr aus der Hauptschleife a heraus. Der Startvorgang über die erste Startschleife b ist dann erforderlich, wenn alle Speicherzellen, also auch die im Kontrollbereich 4, gelöscht sind, also eine logische "0" aufweisen, was meist der gewünschte Anlieferungszustand ist.

Ein ähnlicher Startvorgang beschreibt die zweite Startschleife c, die für den Fall gilt, dass alle Speicherzellen als Inhalt die logische "1" aufweisen. Dann beginnt der Startvorgang beim Zustand c1, dem entweder ein Programmiervorgang Pc 1 oder ein Löschvorgang Lc 1 folgt, die zum Zustand c2 bzw. c3 führen. Zum Zustand c3 kommt man auch über einen Löschvorgang Lc2 vom Zustand c2 aus. Vom Zustand c3 führt schließlich ein Programmiervorgang Pc3 zum Zustand a2 der Hauptschleife a. Damit ist die Hauptschleife a erreicht, die dann Aussagen über den Erfolg oder Misserfolg der weiteren Programmier- oder Löschvorgänge ermöglicht.

Bei der Betrachtung der Zustände b3 und a6 könnte man annehmen, dass es sich um identische Zustände handelt, da die zugehörigen Datenworte "101" identisch sind und beide mittels eines Löschvorganges Lb3 bzw. La6 in den Zustand a1 mit "100" überführt werden. Der Unterschied besteht darin, dass beim Zustand b3 die Kontrollzelle 4.2 keine Information Z über einen vorausgehenden Speichertest enthält. Der logische Inhalt "0" der Kontrollzelle 4.2 entstammt noch mehr oder weniger dem Herstellungsprozess. Beim Zustand a6 in der Hauptschleife a ist diese Information Z, die zeigt, wie sich die Kontrollzelle 4.2 bei dem vorausgehenden Löschtest La4 verhalten hat vorhanden und damit auswertbar.

Für das Ausführungsbeispiel von Fig. 2 wird davon ausgegangen, dass beim Programmieren, das im Diagramm mit einem "P" oder mit Zusätzen "P..." bezeichnet ist, eine Programmierspannung von -7V an die schwebende Steuerelektrode (floating-gate) der jeweiligen Speicher- oder Kontrollzelle angelegt wird und dass beim Löschen, das im Diagramm mit einem "L" oder mit Zusätzen "L..." bezeichnet ist, eine Löschspannung von + 12V angelegt wird. Der Spannungsbereich etwa von 0V bis +2V entspricht einer logischen "0" und der Spannungsbereich etwa von +3V bis +5 V einer logischen "1". Beim Programmieren P bewirkt eine zugeführte "0" keine Änderung der jeweiligen Speicherzelle, unabhängig davon, ob der aktuelle Inhalt eine logische "0" oder "1" ist. Eine zugeführte "1" bewirkt jedoch, dass die "1" in die jeweilige Speicherzelle übernommen also geladen wird. Beim Löschen L bewirkt eine zugeführte "0", dass der Inhalt der Zelle, unabhängig vom vorherigen Zustand, die logische "0" übernimmt, also gelöscht wird. Eine zugeführte "1" bewirkt jedoch keine Änderung des jeweiligen Speicherzelleninhaltes. War dort eine logische "0" gespeichert, dann bleibt dieser Wert erhalten. War der Wert eine logische "1", dann bleibt dieser Wert ebenfalls in der Zelle gespeichert.

Zum Test des jeweiligen Speichervorganges werden in dem dargestellten Ausführungsbeispiel von Fig. 2 die an die Kontrollzellen 4.1 bis 4.3 angelegte Eingangspannungen d1 bis d3 modifiziert. Die Übernahme der an die Kontrollzelle angelegten Eingangsspannung erfolgt nur, wenn die Differenzspannung über die jeweilige schwebende Steuerelektrode (floating-gate) groß genug ist. In unserem Ausführungsbeispiel sind die Speicherzellen im Bereich 5 so ausgelegt, dass die erforderliche Differenzspannung 12V beträgt, die dann auch in dieser Höhe von der Spannungsversorgungseinrichtung zur Verfügung gestellt wird. Im Falle der gleichartigen Kontrollzellen 4.1 bis 4.3 kann für den Test die dortige Differenzspannung durch eine Modifizierung der von der Datenquelle 2 erzeugten Eingangsspannungen d1 bis d3 verkleinert werden, wodurch bei geschädigten Kontrollzellen 4.1 bis 4.3 der Programmier- oder Löscherfolg deutlich abnimmt.

Beim Programmieren P, bei dem eine Programmierspannung von -7V an die schwebenden Steuerelektroden (floating-gate) der Speicher- und Kontrollzellen 4.1 bis 4.3 angelegt wird, spielt eine Modifikation der bei 0 V liegenden Spannung für die logische "0" keine Rolle, denn die resultierende Differenzspannung liegt um die 7V und ist daher zu klein, um etwas in der zugehörigen Kontrollzelle zu bewirken. Anders sieht es mit der bei +5V liegenden logischen "1" aus. Die resultierende Differenzspannung beträgt hierbei 12V und hat damit den geforderten Wert. Wird nun die an eine Kontrollzelle angelegte Eingangsspannung d1 bis d3 auf +4V reduziert, dann entspricht dies immer noch einer logischen "1", aber die resultierende Differenzspannung weist nur noch 11 V auf. Das ist ein Spannungswert, der bei gestörten Speicher- und damit auch Kontrollzellen unter Umständen nicht mehr zum Speichererfolg führt und damit als Testwert für die Messung des Programmiererfolgs dient.

Beim Löschen L, bei dem als Löschspannung +12V an die schwebenden Steuerelektroden (floating-gate) der Speicher- und Kontrollzellen 4.1 bis 4.3 angelegt werden, spielt eine Modifikation der bei +5V liegenden logischen "1" keine Rolle, denn die resultierende Differenzspannung liegt um die 7V und ist zu klein, um etwas in der zugehörigen Kontrollzelle zu bewirken. Anders sieht es mit der bei 0V liegenden Spannung für die logische "0" aus. Die resultierende Differenzspannung beträgt hierbei 12V und hat damit den geforderten Wert. Wird nun die an eine der Kontrollzellen 4.1 bis 4.3 angelegte Eingangsspannung d1 bis d3 auf+1V erhöht, dann entspricht dies immer noch einer logischen "0", aber die resultierende Differenzspannung weist nur noch 11 V auf. Das ist ein Spannungswert, der bei gestörten Speicher- und damit auch Kontrollzellen unter Umständen nicht mehr zum Löscherfolg führt und damit als Testwert für die Messung des Löscherfolgs dient.

Durch die Modifikation der Eingangsspannungen d1 bis d3 hat man ein einfach zu handhabenden Parameter in der Hand, der für den Test der Speichervorgänge zur Verfügung steht. Von großem Vorteil ist dabei, dass über die Höhe der Eingangsspannung d1 bis d3 auch das Maß der Verschlechterung der Kontrollzellen 4.1 bis 4.3 gegenüber den eigentlichen Speicherzellen im Speicherbereich 5 einstellbar ist. Je höher die Abweichungen der Eingangsspannungen d1 bis d3 von den Sollwerten 0V und +5V sind, desto größer ist das Maß der Verschlechterung und desto früher werden gestörte Speicherzellen erkannt.

Für die Überwachung der Speichervorgänge ist es wichtig, dass nicht nur die Übergänge an sich erfasst werden, sondern auch besonders ungünstige Konstellationen dabei. Beispielsweise beim Löschvorgang L einer logischen "1", wenn im Speicher ein besonders hoher Spannungswert vorliegt, also im Bereich von +5V oder noch höher. Wenn die Differenzspannung zu gering ist, die Löschzeit nicht ausreicht oder eine andere Schädigung vorliegt, dann kann dieser Spannungswert nicht tief genug entladen werden, so dass die Auswerteeinrichtung 6 den Inhalt immer noch als eine logische "1" interpretiert. Ähnlich ist es beim Programmiervorgang P einer logischen "1", wenn die zugehörige Speicherzelle als Inhalt eine logische "0" mit einem besonders niedrigen Spannungswert aufweist, also im Bereich von 0V oder gar darunter. Wenn die Differenzspannung zu gering ist, die Programmierzeit nicht ausreicht oder eine andere Schädigung vorliegt, dann kann die von der schwebenden Steuerelektrode (floating-gate) gesteuerte Ladungsübertragung zu gering sein, um den für eine logische "1" erforderlichen Spannungswert zu erreichen. Der Inhalt der Kontrollzelle wird daher von der Auswerteeinrichtung fälschlicherweise als logische "0" interpretiert. Damit der Inhalt der Kontrollzelle, bei der im nächsten Schritt der Test vorgenommen wird, auf einen der ungünstigen Pegel +5V oder 0V eingestellt wird, weist in Fig. 2 jeder Zustand a1 bis a6 der Hauptschleife a eine Kontrollzelle 4.1 bis 4.3 auf, die sich in einem Vorbereitungszustand V befindet. Der gespeicherte Inhalt hat dort entweder den Wert +5V oder 0V, dies richtet sich nach dem nachfolgenden Speichervorgang L bzw. P.

Diejenige der Kontrollzellen 4.1 bis 4.3, an der gerade der aktuelle Speichervorgang L bzw. P als Test vorgenommen wurde, ist in Fig. 2 mit einem M (=Messung) bezeichnet. Der zuvor erfolgte Programmier- oder Löschvorgang P bzw. L wurde mit dem Eingangsspannungswert +4V bzw. +1V durchgeführt. Schließlich gibt es im Ablaufdiagramm von Fig. 2 noch mit einem "Z" bezeichnete Kontrollzellen 4.1 bis 4.3, die als Inhalt den Messwert des vorausgehenden alternativen Speichervorganges enthalten. In der Hauptschleife a befinden sich alle Kontrollzellen 4.1 bis 4.3 in einem der Zustände V, M oder Z. In den beiden Startschleifen b, c ist das nicht der Fall. Bei den Zuständen b2 und c2 ist jeweils nur eine Kontrollzelle vorbereitet. Dies gilt auch für die Zustände b3 und c3, wenn sie direkt vom zugehörigen Startwert b1 bzw. c1 aus erreicht werden. Werden sie dagegen über den Zustand b2 bzw. c2 erreicht, dann ist in der zuvor vorbereiteten Kontrollzelle bereits ein Testvorgang erfolgt, so dass ein Messzustand M in b3 bzw. c3 vorliegt. Der nächste Schritt Lb3 bzw. Pc3 führt dann wie bereits erwähnt in die Hauptschleife a zu den Zuständen a1 bzw. a2, bei denen dann alle Kontrollzellen 4.1 bis 4.3 einen der Zustände V, M, Z aufweisen. Zur Verdeutlichung, welche der Kontrollzellen 4.1 bis 4.3 beim jeweiligen Speichervorgang an dem Zuverlässigkeitstest beteiligt sind, enthält die Hauptschleife a strichpunktierte Pfeile, welche die jeweils am Messvorgang teilnehmende Kontrollzelle hervorhebt. Jede Vorbereitungszelle V wird im nachfolgenden Zustand zur Messzelle M, dies verdeutlichen die strichpunktierten Pfeile.

Für den regulären Ablauf der Speicherfunktion wird ein alternierender Betrieb zwischen Löschen L und Programmieren P angenommen. Um auch bei Abweichungen vom alternierenden Betrieb die Wiederaufnahme des regulären Betriebes möglichst rasch wieder herzustellen, erzeugt die Datenquelle 3 auch für den irregulären Speichervorgang Eingangsdaten d1 bis d3, die in Fig. 2 durch kleine Schleifen P, L bei den einzelnen Zuständen symbolisiert sind. Sie werden dann realisiert, wenn auf einen regulären Löschvorgang L wieder ein oder mehrere Löschvorgänge L folgen. Ebenso, wenn auf einen regulären Speichervorgang P wieder ein oder mehrere Speichervorgänge P folgen. Die Datenquelle 3 versucht dabei den aktuellen Zustand der drei Kontrollzellen 4.1 bis 4.3 möglichst optimal aufrecht zu erhalten.

Für zwei reguläre Programmiervorgänge, die Programmierung Pa5 und die Löschung La6, und zwei irreguläre Programmiervorgänge, die Programmierung Pa6 und die Löschung La1, werden in Fig. 2 die von der Datenquelle 3 gelieferten Eingangsdaten d1 bis d3 in vier separaten Feldern dargestellt. Außer dem logischen Pegel "0" und "1" wird auch der tatsächliche Spannungswert angegeben und ob es sich bei dem jeweiligen Datenwert um einen Testwert T, einen Haltewert H oder einen Vorbereitungswert V* handelt. Mit dem Testwert T wird die Zuverlässigkeitsmessung der jeweiligen Kontrollzelle durchgeführt. Der Haltewert H sorgt nur dafür, dass der in der Zelle vorhandene Spannungswert möglichst gehalten wird. Und der Vorbereitungswert V* versetzt den Inhalt der jeweiligen Kontrollzelle in einen Zustand, der für den nachfolgenden Testvorgang möglichst ungünstig ist. Aus den irregulären Speichervorgängen ist erkennbar, dass es sich dort im wesentlichen um eine Beibehaltung der aktuellen Zustände handelt. Für die eine Kontrollzelle, die sich im Vorbereitungszustand V befindet, wird dieser Zustand zweckmäßigerweise nicht auch noch über eine Haltefunktion H beibehalten sondern als eine neue Vorbereitung V* durchgeführt.

In der Hauptschleife a gibt es keine doppelten Zustände, wohl aber wenn man die beiden Startschleifen b, c mit einbezieht. Das Vorliegen eines Fehlers kann aus den in Fig. 2 dargestellten Zuständen allein nicht ermittelt werden, auch nicht wenn man weiß, welche der Kontrollzellen 4.1 bis 4.3 überhaupt geändert werden soll. Das geht nur, wenn man Kenntnis darüber hat, ob dem aktuellen Zelleninhalt eine Programmierung oder Löschung zugrunde liegt. Der Zustand a2 mit "110" kann eine richtige Folge des Programmierungsschrittes Pa1 sein oder aber eine Folge einer fehlerhaften Löschung La2, die statt des richtigen Zustandes a3 mit "010" zum falschen Ergebnis "110" führt. Wie eine eindeutige Bestätigungs- oder Fehlerinformation ak erhalten wird zeigt beispielsweise Fig. 3.

Fig. 3 zeigt eine zum Ablaufdiagramm von Fig. 2 gehörige Wahrheitstabelle. Sie enthält in vier Spalten von links nach rechts angeordnet den Ausgangsdatenwert k4 der Aktionszelle 4.4 und die Ausgangsdaten k1 bis k3 der drei Kontrollzellen 4.1 bis 4.3. Der Ausgangsdatenwert k4 der Aktionszelle 4.4 gibt an, über welchen Speichervorgang eine Qualitätsaussage gemacht wird. Eine logische "0" entspricht einer Löschung L und eine logische "1" entspricht einer Programmierung P. In der Spalte "+/-" wird angezeigt, ob die vier Ausgangsdaten k1 bis k4 einen erfolgreichen Speichervorgang anzeigen oder nicht; das Pluszeichen "+" steht für einen erfolgreichen und das Minuszeichen "-" für einen nicht erfolgreichen Speichervorgang Ferner enthält die Spalte einen Hinweis auf den vom Hersteller erzeugten ersten Startzustand b 1 bei dem alle Speicherzellen gelöscht sind oder den zweiten möglichen Startzustand c1, bei dem alle Speicherzellen geladen sind, der aber in der Regel nicht erwünscht ist. Die letzte Spalte enthält die von der Auswerteeinrichtung 6 erzeugte Bestätigungsinformation ak, die beispielsweise mit einer logischen "1" einen erfolgreichen Speichervorgang und mit einer logischen "0" einen nicht erfolgreichen Speichervorgang anderen Schaltungsteilen zur Weiterverarbeitung anzeigt.

## Patentansprüche

1. Verfahren zur Kontrolle der Programmierung (P) und Löschung (L) von Speicherzellen (5) bei einer nichtflüchtigen Speichereinrichtung (1) bei dem parallel zur Programmierung (P) oder Löschung (L) der Speicherzellen (5), die von einer mitintegrierten Steuereinrichtung (2) gesteuert werden, eine Programmierung (P) oder Löschung (L) an mindestens einer in der nichtflüchtigen Speichereinrichtung (1) enthaltenen gleichartigen Kontrollzelle (4.1, 4.2, 4.3) durchgeführt wird, **dadurch gekennzeichnet, dass** eine Programmierung (P) oder Löschung (L) der Kontrollzellen wenigstens mit einer geringeren Differenzspannung zwischen einem Spannungswert der Eingangsdaten (d1-d4) und der Höhe einer Programmier- oder Löschspannung und/oder mit einer geringeren Dauer eines Anlegens der Programmier- oder Löschspannung als bei der Programmierung (P) oder Löschung (L) der eigentlichen Speicherzellen (5) erfolgt.

2. Verfahren nach Anspruch 1, **dadurch gekennzeichnet, dass** die Programmierung (P) oder Löschung (L) der mindestens einen Kontrollzelle (4.1, 4.2, 4.3) mindestens in einem Parameter definiert ungünstiger ist als bei den Speicherzellen (5).

3. Verfahren nach Anspruch 1 oder 2, **dadurch gekennzeichnet, dass** eine Auswerteeinrichtung (6), nach Ablauf der Programmierung (P) oder Löschung (L) in Abhängigkeit vom Inhalt der mindestens einen Kontrollzelle (4.1, 4.2, 4.3) eine positive oder negative Bestätigungsinformation (ak) erzeugt.

4. Verfahren nach Anspruch 1, **dadurch gekennzeichnet, dass** eine Datenquelle (3) ein mindestens eine Stelle umfassendes Datenwort (d1, d2, d3, d4) erzeugt und damit die mindestens eine Kontrollzelle (4.1, 4.2, 4.3) ansteuert.

5. Verfahren nach Anspruch 4, **dadurch gekennzeichnet, dass** bei einem Wechsel des Speichervorganges die Datenquelle (3) ein mindestens zwei Stellen umfassendes Datenwort (d1, d2, d3, d4) so vorgibt, dass mindestens eine Stelle des Datenworts unter normalen Parameterbedingungen eine Änderung des logischen Zustandes in der zugehörigen Kontrollzelle (4.1, 4.2, 4.3) bewirkt, wobei der tatsächliche Speichervorgang dieser Stelle aber unter ungünstigeren Parameterbedingungen erfolgt.

6. Verfahren nach Anspruch 4 oder 5, **dadurch gekennzeichnet, dass** das von der Datenquelle (3) erzeugte Datenwort (d1, d2, d3, d4) mindestens eine Vorbereitungsstelle (V*) enthält, die der Vorbereitung des Tests (T) für eine nachfolgende Programmierung (P) oder Löschung (L) dient, wobei die der Vorbereitungsstelle (V*) zugeordnete Kontrollzelle (4.1, 4.2, 4.3) in einen vom durchzuführenden Speichervorgang (P, L) abhängigen Vorbereitungszustand (V) gebracht wird.

7. Verfahren nach einem der Ansprüche 1 bis 6, **dadurch gekennzeichnet, dass** der für die Programmierung (P) oder Löschung (L) modifizierbare Parameter die von der Steuereinrichtung (2) vorgegebene Höhe der Programmier- oder Löschspannung ist.

8. Verfahren nach einem der Ansprüche 1 bis 6, **dadurch gekennzeichnet, dass** der für die Programmierung (P) oder Löschung (L) modifizierbare Parameter die von der Steuereinrichtung (2) vorgegebene Dauer der Programmier- oder Löschspannung ist.

9. Verfahren nach einem der Ansprüche 1 bis 6, **dadurch gekennzeichnet, dass** der für die Programmierung (P) oder Löschung (L) modifizierbare Parameter die von der Steuereinrichtung (2) und der Datenquelle (3) vorgegebene Differenzspannung zwischen den Spannungswerten der Eingangsdaten (dlbis d4) und der Höhe der Programmier- oder Löschspannung ist.

10. Verfahren nach Anspruch 9, **dadurch gekennzeichnet, dass** die Höhe der Differenzspannung über den von der Datenquelle (3) erzeugten Spannungswert für die logische "0" oder "1" für die jeweilige Stelle der Eingangsdaten (d1 bis d4) separat eingestellt wird.

11. Verfahren nach Anspruch 1, **dadurch gekennzeichnet, dass** die Auswerteeinrichtung (6) den Erfolg der Programmierung (P) oder Löschung (L) aus der Spannungshöhe des Inhalts der mindestens einen Kontrollzelle (4.1, 4.2, 4.3) bestimmt, wobei entweder die absolute Spannungshöhe ausgewertet wird oder die Auswertung über einen Vergleich mit einem Schwellwert erfolgt.

12. Verfahren nach Anspruch 11, **dadurch gekennzeichnet, dass** die Auswerteeinrichtung (6) den Inhalt der mindestens einen Kontrollzelle (4.1, 4.2, 4.3) als logische "1" oder "0" verarbeitet, wenn die Spannungshöhe den Schwellwert über- bzw. unterschreitet.

13. Verfahren nach Anspruch 12, **dadurch gekennzeichnet, dass** die Datenquelle (2) in der Art einer logisch gesteuerten Abfolge von Zuständen (a1 bis a6) aus den jeweiligen Ausgangsdaten (k1, k2, k3) mindestens zweier Kontrollzellen (4.1, 4.2, 4.3) in Verbindung mit der vorgesehenen Programmierung (P) oder Löschung (L) das neue Datenwort (d1, d2, d3, d4) erzeugt.

14. Verfahren nach Anspruch 13, **dadurch gekennzeichnet, dass** die Auswerteeinrichtung (6) die Ausgangsdaten (k1, k2, k3) der Kontrollzellen (4.1, 4.2, 4.3) mit einem Solldatenwort vergleicht, das aus der logisch gesteuerten Abfolge der Zustände (a1 bis a6) in Verbindung mit der jeweils durchgeführten Programmierung (P) oder Löschung (L) gebildet wird.

15. Verfahren nach Anspruch 14, **dadurch gekennzeichnet, dass** die Ausgangsdaten (k1, k2, k3) der Kontrollzellen (4.1, 4.2, 4.3) außer dem Ergebnis (M) des aktuellen Speichervorganges auch das Ergebnis (Z) des vorausgehenden alternativen Spcichervorganges (P, L) enthalten.

16. Nichtflüchtige Speichereinrichtung (1) mit einer Steuereinrichtung (2) für die Programmierung (P) und Löschung (L) von Speicherzellen (5), **gekennzeichnet durch** folgende Merkmale:
- die nichtflüchtige Speichereinrichtung (1) enthält mindestens eine Kontrollzelle (4.1, 4.2, 4.3), die gleichartig zu den Speicherzellen (5) ist und mit diesen zusammen programmiert oder gelöscht wird, wobei die Steuereinrichtung (2) derart ausgebildet ist, dass die Programmierung (P) oder Löschung (L) dieser Kontrollzelle (4.1, 4.2, 4.3) wenigstens mit einer geringeren Differenzspannung zwischen einem Spannungswert der Eingangsdaten (d1-d4) und der Höhe einer Programmiert- oder Löschspannung und/oder mit einer geringeren Dauer eines Anlegens der Programmier- oder Löschspannung als bei den Speicherzellen (5) erfolgt
- mit der Steuereinrichtung (2) ist eine Datenquelle (3) verkoppelt, die Daten (d1, d2, d3, d4) für die mindestens eine Kontrollzelle (4.1, 4.2, 4.3) in Abhängigkeit von der aktuell durchzuführenden Programmierung (P) oder Löschung (L) erzeugt und
- eine Auswerteeinheit (6), die eingangsseitig mit der mindestens einen Kontrollzelle (k1, k2, k3) verbunden ist, erzeugt eine positive oder negative Bestätigungsinformation (ak).

17. Nichtflüchtige Speichereinrichtung (1) nach Anspruch 16, **dadurch gekennzeichnet, dass** eine Zustandsmaschine mit der Datenquelle (3) und mindestens zwei Kontrollzellen (4.1, 4.2, 4.3) gekoppelt ist.

18. Nichtflüchtige Speichereinrichtung (1) nach Anspruch 17, **dadurch gekennzeichnet, dass** die Zustandsmaschine eine Rückkopplung der Ausgangsdaten (k1, k2, k3) der mindestens zwei Kontrollzellen (4.1, 4.2, 4.3) auf zugeordnete Eingänge der Datenquelle (3) aufweist.

19. Nichtflüchtige Speichereinrichtung (1) nach Anspruch 16, **dadurch gekennzeichnet, dass** die Steuereinrichtung (2) an die Datenquelle (3) Steuerdaten (p,1) liefert, die signalisieren, ob der aktuell durchzuführende Speichervorgang eine Programmierung (P) oder Löschung (L) ist.

20. Nichtflüchtige Speichereinrichtung (1) nach Anspruch 19, **dadurch gekennzeichnet, dass** die Steuerdaten (p, 1) einer Zustandsmaschine als Steuerinformation zugeführt sind.

21. Nichtflüchtige Speichereinrichtung (1) nach einem der Ansprüche 16 bis 20, **dadurch gekennzeichnet, dass** die Spannungshöhen der den Kontrollzellen (4.1 bis 4.3) zugeführten Eingangsdaten (d1, d2, d3, d4) jeweils einzeln steuerbar sind.

22. Nichtflüchtige Speichereinrichtung (1) nach Anspruch 21, **dadurch gekennzeichnet, dass** die jeweilige Spannungshöhe der Eingangsdaten (d1, d2, d3, d4) von der Zustandsmaschine gesteuert ist.

23. Nichtflüchtige Speichereinrichtung (1) nach Anspruch 19 oder 20, **dadurch gekennzeichnet, dass** die Datenquelle (3) in Abhängigkeit von den aktuellen Steuerdaten (p, 1) eine zugehörige Stelle (d4) der Eingangsdaten (d1, d2, d3, d4) setzt und diese in einer Aktionszelle (4.4) speichert, deren Inhalt zusammen mit dem Inhalt der Kontrollzellen (4.1 bis 4.3) das Ausgangsdatenwort (k1 bis k4) bildet.

24. Nichtflüchtige Speichereinrichtung (1) nach Anspruch 16, **dadurch gekennzeichnet, dass** die Auswerteeinrichtung (6) zur Erzeugung der positiven oder negativen Bestätigungsinformation (ak) eine Wahrheitstabelle aufweist.

25. Nichtflüchtige Speichereinrichtung (1) nach Anspruch 23 und 24, **dadurch gekennzeichnet, dass** die Ausgangsdaten (k1 bis k4) der Kontrollzellen (4.1 bis 4.3) und der Aktionszelle (4.4) als Adressen für die Wahrheitstabelle dienen.

## Claims

1. Method of checking the programming (P) of and erasure (L) from memory cells (5) in a non-volatile memory device (1), in which carried out in parallel with the programming (P) of or erasure (L) from the memory cells (5), which are controlled by a control device (2) integrated therewith, is programming (P) of or erasure (L) from at least one identical control cell (4.1, 4.2, 4.3) present in the non-volatile memory device (1), **characterised in that** programming (P) of or erasure (L) from the control cells is carried out at least with a smaller voltage difference between a voltage value of the input data (d1 - d4) and the level of a programming or erasing voltage and/or with a smaller duration of application of the programming or erasing voltage than for the programming (P) of or erasure (L) from the actual memory cells (5).

2. Method according to claim 1, **characterised in that** the programming (P) of or erasure (L) from the at least one control cell (4.1, 4.2, 4.3) is less favourably defined in at least one parameter than for the memory cells (5).

3. Method according to claim 1 or 2, **characterised in that** an evaluating device (6) generates a positive or negative item of confirmatory information (ak) after expiry of the programming (P) or erasure (L) in dependence on the content of the at least one control cell (4.1, 4.2, 4.3).

4. Method according to claim 1, **characterised in that** a data source (3) generates a data word (d1, d2, d3, d4) having at least one place and thus activates the at least one control cell (4.1, 4.2, 4.3).

5. Method according to claim 4, **characterised in that** in the case of change of the storage process the data source (3) so predetermines a data word (d1, d2, d3, d4) having at least two places that at least one place of the data word under normal parameter conditions produces a change in the logic state in the associated control cell (4.1, 4.2, 4.3), wherein, however, the actual storage process of this place takes place under less favourable parameter conditions.

6. Method according to claim 4 or 5, **characterised in that** the data word (d1, d2, d3, d4) generated by the data source (3) includes at least one preparation place (V*), which serves for the preparation of the test (T) for a succeeding programming (P) or erasure (L), wherein the control cell (4.1, 4.2, 4.3) associated with the preparation place (V*) is brought into a preparation state (V) dependent on the storage process (P, L) to be undertaken.

7. Method according to any one of claims 1 to 6, **characterised in that** the parameter modifiable for the programming (P) or erasure (L) is the level of the programming or erasing voltage predetermined by the control device (2).

8. Method according to any one of claims 1 to 6, **characterised in that** the parameter modifiable for the programming (P) or erasure (L) is the duration of the programming or erasing voltage predetermined by the control device (2).

9. Method according to any one of claims 1 to 6, **characterised in that** the parameter modifiable for the programming (P) or erasure (L) is the voltage difference, which is predetermined by the control device (2) and the data source (3), between the voltage values of the input data (d1 to d4) and the level of the programming or erasing voltage.

10. Method according to claim 9, **characterised in that** the level of the voltage difference is separately set for the respective place of the input data (d1 to d4) by way of the voltage value, which is generated by the data source (3), for logic '0' or'1'.

11. Method according to claim 1, **characterised in that** the evaluating device (6) determines the success of the programming (P) or erasure (L) from the voltage level of the content of the at least one control cell (4.1, 4.2, 4.3), wherein either the absolute voltage level is evaluated or the evaluation is carried out by way of comparison with a threshold value.

12. Method according to claim 11, **characterised in that** the evaluating device (6) processes the content of the at least one control cell (4.1, 4.2, 4.3) as a logic'1' or '0' if the voltage level exceeds or falls below the threshold value.

13. Method according to claim 12, **characterised in that** the data source (2) generates the new data word (d1, d2, d3, d4) in the manner of a logically controlled sequence of states (a1 to a6) from the respective output data (k1, k2, k3) of at least two control cells (4.1, 4.2, 4.3) in conjunction with the intended programming (P) or erasure (L).

14. Method according to claim 13, **characterised in that** the evaluating device (6) compares the output data (k1, k2, k3) of the control cells (4.1, 4.2, 4.3) with a target data word which is formed from the logically controlled sequence of the states (a1 to a6) in conjunction with the respectively performed programming (P) or erasure (L).

15. Method according to claim 14, **characterised in that** the output date (k1, k2, k3) of the control cells (4.1, 4.2, 4.3) include, apart from the result (M) of the current storage process, also the result (Z) of the preceding alternative storage process (P, L).

16. Non-volatile memory device (1) with a control device (2) for the programming (P) of and erasure (L) from memory cells (5), **characterised by** the following features:
- the non-volatile memory device (1) includes at least one control cell (4.1, 4.2, 4.3) which is identical with the memory cells (5) and is programmed or cleared together therewith, wherein the control device (2) is constructed in such a manner that the programming (P) of or erasure (L) from this control cell (4.1, 4.2, 4.3) is carried out at least with a smaller voltage difference between a voltage value of the input data (d1 - d4) and the level of a programming or erasing voltage and/or with a smaller duration of application of the programming or erasing voltage than for the memory cells (5),
- a data source (3) is coupled with the control device (2) and generates the data (d1, d2, d3, d4) for the at least one control cell (4.1, 4.2, 4.3) in dependence on the currently performed programming (P) or erasure (L) and
- an evaluating unit (6) connected at the input side with the at least one control cell (k1, k2, k3) generates a positive or negative item of confirmatory information (ak).

17. Non-volatile memory device (1) according to claim 16, **characterised in that** a state machine is coupled with the data source (3) and at least two control cells (4.1, 4.2, 4.3).

18. Non-volatile memory device (1) according to claim 17, **characterised in that** the state machine has a feedback of the output data (k1, k2, k3) of the at least two control cells (4.1, 4.2, 4.3) to associated inputs of the data source (3).

19. Non-volatile memory device (1) according to claim 16, **characterised in that** the control device (2) supplies to the data source (3) control data (p, l) which signal whether the currently performed memory process is a programming (P) or an erasure (L).

20. Non-volatile memory device (1) according to claim 19, **characterised in that** the control data (p, l) of a state machine are supplied as control information.

21. Non-volatile memory device (1) according to any one of claims 16 to 20, **characterised in that** the voltage levels of the input data (d1, d2, d3, d4) supplied to the control cells (4.1 to 4.3) are individually controllable.

22. Non-volatile memory device (1) according to claim 21, **characterised in that** the respective voltage level of the input data (d1, d2, d3, d4) is controlled by the state machine.

23. Non-volatile memory device (1) according to claim 19 or 20, **characterised in that** the data source (3) sets an associated place (d4) of the input data (d1, d2, d3, d4) in dependence on the current control data (p, I) and stores this in an action cell (4.4), the content of which together with the content of the control cells (4.1, to 4.3) forms the output data word (k1 to k4).

24. Non-volatile memory device (1) according to claim 16, **characterised in that** the evaluating device (6) has a truth table for generating the positive or negative item of confirmatory information (ak).

25. Non-volatile memory device (1) according to claim 23 and 24, **characterised in that** the output data (k1 to k4) of the control cells (4.1 to 4.3) and the action cell (4.4) serve as addresses for the truth table.

## Revendications

1. Procédé de contrôle de la programmation (P) et de l'effacement (L) de cellules mémoire (5) dans une mémoire (1) non volatile, selon lequel, parallèlement à la programmation (P) ou à l'effacement (L) des cellules mémoire (5), commandés par un dispositif de commande (2) intégré, une programmation (P) ou un effacement (L) est effectué(e) sur au moins une cellule de contrôle (4.1, 4.2, 4.3) de même type, contenue dans la mémoire (1) non volatile, **caractérisé en ce qu'**une programmation (P) ou un effacement (L) des cellules de contrôle s'effectue au moins par une plus faible tension différentielle entre une valeur de tension des données d'entrée (d1 à d4) et la valeur d'une tension de programmation ou d'effacement et/ou avec une plus faible durée d'une application de la tension de programmation ou d'effacement, que dans le cas de la programmation (P) ou de l'effacement (L) des cellules mémoire (5) proprement dites.

2. Procédé selon la revendication 1, **caractérisé en ce que** la programmation (P) ou l'effacement (L) de la au moins une cellule de contrôle (4.1, 4.2, 4.3), au moins en un paramètre, est défini(e) de manière plus désavantageuse dans pour les cellules mémoire (5).

3. Procédé selon la revendication 1 ou 2, **caractérisé en ce que**, après expiration de la programmation (P) ou de l'effacement (L), en fonction du contenu de la au moins une cellule de contrôle (4.1, 4.2, 4.3), un dispositif d'évaluation (6) génère une information de confirmation (ak) positive ou négative.

4. Procédé selon la revendication 1, **caractérisé en ce qu'**une source de données (3) génère un mot de données (d1, d2, d3, d4) comprenant au moins un emplacement et commande ainsi la au moins une cellule de contrôle (4.1, 4.2, 4.3).

5. Procédé selon la revendication 4, **caractérisé en ce que**, dans le cas d'un changement du processus de stockage en mémoire, la source de données (3) attribue un mot de données (d1, d2, d3, d4) comprenant au moins deux emplacements, **en ce qu'**au moins un emplacement du mot de données provoque, dans des conditions de paramètre normales, une modification de l'état logique dans la cellule de contrôle (4.1, 4.2, 4.3) afférente, le processus de stockage en mémoire effectif de cet emplacement s'effectuant cependant dans des conditions de paramètre plus désavantageuses.

6. Procédé selon la revendication 4 ou 5, **caractérisé en ce que** le mot de données (d1, d2, d3, d4) généré par la source de données (3) contient au moins un emplacement de préparation (V*), servant à la préparation du test (T) pour une programmation (P) ou effacement (L) subséquent, la cellule de contrôle (4.1, 4.2, 4.3) associée à l'emplacement de préparation (V*) étant placée en un état de préparation (V) dépendant du processus de stockage mémoire (P, L) à accomplir.

7. Procédé selon l'une des revendications 1 à 6, **caractérisé en ce que** le paramètre, modifiable pour la programmation (P) ou l'effacement (L), est la valeur, prédéterminée par le dispositif de commande (2), de la tension de programmation ou d'effacement.

8. Procédé selon l'une des revendications 1 à 6, **caractérisé en ce que** le paramètre, modifiable pour la programmation (P) ou l'effacement (L), est la durée, prédéterminée par le dispositif de commande (2), de la tension de programmation ou d'effacement.

9. Procédé selon l'une des revendications 1 à 6, **caractérisé en ce que** le paramètre, modifiable pour la programmation (P) ou l'effacement (L), est la tension différentielle, prédéterminée par le dispositif de commande (2) et la source de données (3), entre les valeurs de tension des données d'entrée (d1 à d4) et la valeur de la tension de programmation ou d'effacement.

10. Procédé selon la revendication 9, **caractérisé en ce que** la valeur de la tension différentielle est réglée séparément pour l'emplacement respectif des données d'entrée (d1 à d4), par l'intermédiaire de la valeur de tension, générée par la source de données (3), pour le "0" ou le "1" logique.

11. Procédé selon la revendication 1, **caractérisé en ce que** le dispositif d'évaluation (6) détermine le succès de la programmation (P) ou de l'effacement (L), à partir de la valeur de tension du contenu de la au moins une cellule de contrôle (4.1, 4.2, 4.3), sachant que soit la valeur de tension absolue est évaluée, soit l'évaluation s'effectue par l'intermédiaire d'une comparaison avec une valeur de seuil.

12. Procédé selon la revendication 11, **caractérisé en ce que** le dispositif d'évaluation (6) traite le contenu de la au moins une cellule de contrôle (4.1, 4.2, 4.3) sous forme de "1" ou de "0" logique, lorsque la valeur de tension dépasse la valeur seuil ou lui devient inférieure.

13. Procédé selon la revendication 12, **caractérisé en ce que** °' là source de données (2) génère le nouveau mot de données (d1, d2, d3, d4) à la manière d'une succession, commandée de manière logique, d'états (a1 à a6), à partir des données de sortie (k1, k2, k3) respectives d'au moins deux cellules de contrôle (4.1, 4.2, 4.3), en liaison avec la programmation (P) ou l'effacement (L) prévu.

14. Procédé selon la revendication 13, **caractérisé en ce que** le dispositif d'évaluation (6) compare les données de sortie (k1, k2, k3) des cellules de contrôle (4.1, 4.2, 4.3) à un mot de données de consigne, formé à partir de la succession, commandée de manière logique, des états (a1 à a6), en liaison avec la programmation (P) ou l'effacement (L) chaque fois effectué(e).

15. Procédé selon la revendication 14, **caractérisé en ce que** les données de sortie (k1, k2, k3) des cellules de contrôle (4.1, 4.2, 4.3), outre le résultat (M) du processus de stockage mémoire actuel, contiennent également le résultat (Z) du processus de stockage mémoire (P, L) alternatif précédent.

16. Mémoire (1) non volatile, avec un dispositif de commande (2) pour la programmation (P) et l'effacement (L) de cellules mémoire (5), **caractérisé par** les caractéristiques suivantes :
- la mémoire (1) non volatile contient au moins une cellule de contrôle (4.1, 4.2, 4.3), qui est du même type que les cellules mémoire (5) et est programmée ou effacée conjointement avec celles-ci, le dispositif de commande (2) étant réalisé de manière que la programmation (P) ou l'effacement (L) de cette cellule de contrôle (4.1, 4.2, 4.3) s'effectue au moins avec une plus faible tension différentielle entre une valeur de tension des données d'entrée (d1 à d4) et la valeur d'une tension de programmation ou d'effacement et/ou avec une plus faible durée d'une application de la tension de programmation ou d'effacement, que dans le cas des cellules mémoire (5),
- une source de données (2), générant des données (d1, d2, d3, d4) pour la au moins une cellule de contrôle (4.1, 4.2, 4.3), en fonction de la programmation (P) ou effacement (L) en cours, est couplée au dispositif de commande (2), et
- une unité d'évaluation (6), reliée, côté entrée, à la au moins une cellule de contrôle (k1, k2, k3), génère une information de confirmation (ak) positive ou négative.

17. Mémoire (1) non volatile selon la revendication 16, **caractérisée en ce qu'**une machine à états est couplée à la source de données (3) et à au moins deux cellules de contrôle (4.1, 4.2, 4.3).

18. Mémoire (1) non volatile selon la revendication 17, **caractérisée en ce que** la machine à états présente une rétroaction des données de sortie (k.1, k.2, k.3) des au moins deux cellules de contrôle (4.1, 4.2, 4.3) à des entrées associées de la source de données (3).

19. Mémoire (1) non volatile selon la revendication 16, **caractérisée en ce que** le dispositif de commande (2) fournit à la source de données (3) des données de commande (p, I), signalant si le processus de stockage mémoire en cours est une programmation (P) ou un effacement (L).

20. Mémoire (1) non volatile selon la revendication 19, **caractérisée en ce que** les données de commande (p, I) sont amenées à une machine à états, à titre d'information de commande.

21. Mémoire (1) non volatile selon l'une des revendications 16 à 20, **caractérisée en ce que** les valeurs de tension, des données d'entrées (d1, d2, d3, d4) amenées aux cellules de contrôle (4.1 à 4.3), sont susceptibles d'être commandées chacune individuellement.

22. Mémoire (1) non volatile selon la revendication 21, **caractérisée en ce que** la valeur de tension respective des données d'entrées (d1, d2, d3, d4) est commandée par la machine à états.

23. Mémoire (1) non volatile selon la revendication 19 ou 20, **caractérisée en ce que** la source de données (3), en fonction des données de commande (p, I) actuelles, fixe un emplacement (d4) afférent des données d'entrées (d1, d2, d3, d4) et stocke en mémoire celles-ci dans une cellule d'action (4.4), dont le contenu forme, conjointement avec le contenu des cellules de contrôle (4.1 à 4.3), le mot de données de sortie (k1 à k4).

24. Mémoire (1) non volatile selon la revendication 16, **caractérisée en ce que** le dispositif d'évaluation (6) servant à générer l'information de confirmation (ak) positive ou négative présente une table de vérité.

25. Mémoire (1) non volatile selon les revendications 23 et 24, **caractérisée en ce que** les données de sortie (k1 à k4) des cellules de contrôle (4.1 à 4.3) et de la cellule d'action (4.4) servent d'adresses pour la table de vérité.
